(19) Europäisches Patentamt
European Patent Office
Office européen des brevets

(11) Publication number: 0 002 625
B1

# (12) EUROPEAN PATENT SPECIFICATION

(45) Date of publication of patent specification: 12.05.82

(51) Int. Cl.³: C 08 F 2/50, C 08 F 283/00, G 03 C 1/68

(21) Application number: 78300864.2

(22) Date of filing: 19.12.78

## (54) Photocurable compositions, photoactivator- photoinitiator combinations useful therein and method of making cured plastics compositions therefrom.

(30) Priority: 19.12.77 GB 5278377

(43) Date of publication of application: 27.06.79 Bulletin 79/13

(45) Publication of the grant of the patent: 12.05.82 Bulletin 82/19

(84) Designated Contracting States: BE CH DE FR GB IT NL SE

(56) References cited: US - A - 3 759 807

(73) Proprietor: WARD BLENKINSOP AND COMPANY LIMITED
Fulton House Empire Way
Wembley, Middlesex HA9 0LX (GB)

(72) Inventor: Green, Peter Nicholl
8 Quickswood Drive
Woolton, Liverpool, L25 4TR (GB)
Inventor: Young, Joseph Robert Alan
10a Sayce Street
Widnes, Cheshire (GB)
Inventor: Read, Harold Cleveland
3 Denhall Close
Upton Park, Chester, CH2 2HT (GB)

(74) Representative: Pennant, Pyers et al,
Stevens, Hewlett & Perkins 5 Quality Court
Chancery Lane
London, WC2A 1HZ (GB)

EP 0 002 625 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Photocurable compositions, photoactivator-photoinitiator combinations useful therein and method of making cured plastics compositions therefrom

This invention relates to photocurable compositions, to combinations of photoactivators and photoinitiators useful therein and to their use in making photocured resins, especially pigmented resins and in particular to resins pigmented with titanium dioxide.

Photoactivators are compounds, usually organic compounds, which form synergistic combinations with photoinitiators in the photocuring of ethylenically unsaturated resins. In the photocuring of such resins the photoinitiator is a compound which will absorb light energy from the curing radiation to give an energetic species which can start a chain reaction to cross-link and thus cure the resin. It is believed that photoactivators take part in the chain by having a proton abstracted by the energetic species of the photoinitiator to produce a free radical which can subsequently initiate crosslinking.

Most photoinitiators in current use are ketones or ketone derivatives. Typical examples are acetophenone, benzophenone, benzil, benzoin, xanthone, thioxanthone and substituted forms and derivatives of these compounds. 2-substituted thioxanthones, especially 2-chlorothioxanthone (2-CTX) and the 2-alkylthioxanthones are particularly useful where $TiO_2$ pigments are used because they have a photoactive absorption band centred about 380 nm and this is in the transitional region between the lower wavelength end of the high reflectivity and the upper wavelength end of the U.V. absorption band of $TiO_2$.

Typically the photoactivators in current use are amines and in particular tertiary amines. Typical examples include triethylamine, triethanolamine, methyldiethanolamine, dimethylaniline and morpholine. Recently the use of para-dialkylaminobenzoic acid esters has been suggested in German Offenlegungsschrift No. 2458345. Further, we have found that ortho-dialkylaminobenzoate esters are useful photoactivators and their use, as such, is the subject of our British Patent Application No. 52202/76 (Specification No. 1547919).

One disadvantage of 2-chloro and 2-alkyl thioxanthones is that they are solids. Since in most photocuring systems it is preferred to avoid the introduction of solvent which would have to be subsequently removed from the system, those photoinitiators have to be milled into the composition to be photocured. The lower members of the homologous series of paradialkylaminobenzoate esters are also all solids and this constitutes a substantial disadvantage of what would otherwise be very attractive photactivators.

This invention is based on the discovery that certain dialkylaminoalkyl benzoates are also potent activators.

The present invention accordingly provides a photocurable composition comprising a photocurable ethylenically unsaturated compound, a photoinitiator and a photoactivator characterised in that the photoactivator comprises a compound or a mixture of compounds of the general formula:

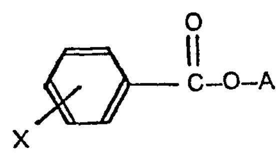

where

A is a group of the formula:

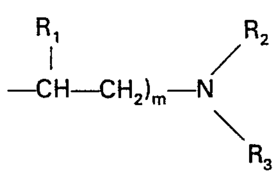

where

m is an integer of from 1 to 5;

$R_1$ is a hydrogen atom or a straight or branched chain alkyl group preferably having from 1 to 3 carbon atoms;

$R_2$ and $R_3$ are the same or different and each is an alkyl preferably a methy or ethyl group;

X is a hydrogen or a halogen atom preferably a chlorine or bromine atom or a straight or branched chain alkyl or alkoxy group preferably having from 1 to 6 carbon atoms or a group of the formula:

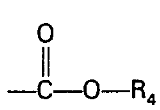

where

$R_4$ is a hydrogen atom, a straight or branched chain alkyl group preferably having from 1 to 6 carbon atoms,

or (and preferably) a group of the formula A as defined above or X is an alkylthio group, preferably having from 1 to 6 carbon atoms.

We believe that the position of the group X (where it is other than a hydrogen atom) relative to the carboxyl function in the ring ·is not as critical as with the N,N-dialkylamino ortho- and para-benzoates. However, as a practical matter it is likely that the ortho- and para-compounds will be used because the corresponding ortho- and para-starting materials are more readily available than the metaisomers. When the photoactivator contains two groups of the formula A these groups can be the same or different within the definition of A.

The photoinitiators used in this invention are typically di-aryl ketones. This type of photoinitiator is commonly used with photoactivators in particular when used in pigmented resin systems. The simplest di-aryl ketones photoinitiators are those of the benzophenone type the most commonly used compound being benzophenone itself. The photoactivators used in the present invention can be used with benzophenone but we have obtained better results from di-aryl ketone photoinitiators in which the two aryl groups are linked to give a cyclic ketone. Examples of such ketone photoinitiators include 2-substituted thioxanthones, especially 2-chloro- and 2-alkyl-thioxanthones, dibenzosuberone and fluorenone. We have found that benzil photoinitiators also work with the photoactivators used in the present invention and for the purpose of this invention we include benzil i.e. 1,2-diphenylethane-1,2-dione and substituted benzils, but not functional derivatives of the oxo-groups, within the term di-aryl ketone.

The invention includes a photoinitiator-photoactivator composition characterized in that the photoactivator comprises a compound or a mixture of compounds of the formula:

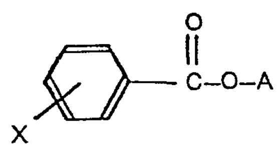

where A and X are as defined above.

The invention further includes a method of making cured plastics composition characterised in that it comprises exposing a composition of the invention to a dose of actinic radiation sufficient to cure it.

It is a particular advantage of the compounds used as photoactivators in the present invention that generally they are liquids and that at least the most commonly used 2-alkylthioxanthones, 2-methylthioxanthone, the 2-isopropylthioxanthones and 2-tertiarybutylthioxanthone are readily soluble, e.g. up to 50 g. per 100 g. ester and 2-chlorothioxanthone has a significant solubility sufficient that in curing resins the necessary 2—CTX can be completely dissolved in the ester. Accordingly, in a preferred aspect the invention further provides a photoinitiator-photoactivator composition characterised in that it comprises a photoinitiator of the formula:

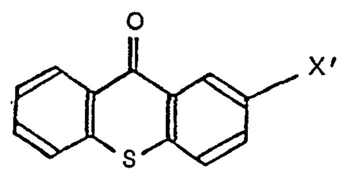

where X′ is a chlorine atom (giving 2—CTX) or an alkyl group (giving the 2-alkylTX's), preferably a straight or branched chain $C_1$ to $C_{10}$ alkyl group; in solution in a photoactivator which is a compound or a mixture of compounds of the formula:

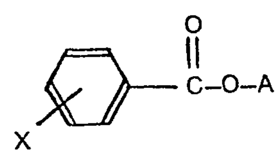

The photoactivators are useful generally in the photocuring of resins containing cross-linkable ethylenically unsaturated compounds. Typically the ethylenic unsaturations are provided by including oligomeric olefins or unsaturated polyesters, e.g. those made including an unsaturated acid such as maleic, fumaric or itaconic acid. The unsaturation may be introduced into the resin either by copolymerising a suitable ethylenically unsaturated monomer with the other components of the resin or by mixing a separately formed polymer containing ethylenic unsaturations with a polymer containinig no ethylenic unsaturations. The choice in any particular case will depend upon the desired properties in the end product. Suitable polymer resins are acrylic resins, acrylated aromatic or aliphatic polyurethane resins, epoxy acrylate resins and styrene polyester resins.

The amount of photoactivator used depends on the nature of the resin, the amount and nature of the pigment and the particular photoinitiator used. Typically to ensure adequate photoactivation the

amount used will be from 0.2 to 5%, preferably 1 to 3%, by weight of the composition. The amount of photoinitiator depends on the particular photoinitiator employed, but will typically be in the range 0.1 to 5% by weight of the composition. When 2—CTX or 2-alkylTX is used as the photoinitiator, the amount used will usually be in the lower part of this range, e.g. 0.2 to 1, preferably 0.2 to 0.5. These figures represent practical levels of photoactivator and photoinitiator in $TiO_2$ pigmented systems even at high pigment levels, e.g. up to 50% by weight of the composition. When other pigments are used the amount of photoinitiator will be selected accordingly but this is regarded as within the skill in the art. The ratio between the photoactivator and photoinitiator is not believed to be especially critical but is generally in the range 1:4 to 100:1. Especially when 2—CTX is the photoinitiator it is preferable that this ratio is fairly high, e.g. in the range 4:1 to 20:1 because the use of large quantities of 2—CTX tends to produce a yellow colour in the cured resin. The photoactivators used in the present invention are sufficiently potent that such low levels, both relatively and absolutely, of 2—CTX can still produce good results.

Where, as is preferred, the photoactivator-photoinitiator combination is a solution of 2—CTX or 2-alkylTX in the benzoate ester, the amount of this combination used will typically be from 1 to 5% by weight of the composition. The solution will typically contain from 1 to 20% by weight of the photoinitiator. However, where 2-chlorothioxanthone is the photoinitiator the concentration will generally be in the range of 1 to 5% because of the rather limited solubility of the commercially available forms of 2—CTX. Technical grade 2—CTX available at the present time typically contains about 65% by weight of 2-chlorothioxanthone and about 35% by weight of 3-chlorothioxanthone which is somewhat less active than the 2-isomer. This material is soluble in ethyl *o*-dimethylaminobenzoate to about 10% $^{w}/_{w}$.

The resins used in the invention are generally photocured by exposure to ultraviolet or short wavelength visible light, the precise wavelength or range of wavelengths depending on the pigment and photoinitiator used. Where, as is preferred in the present invention the pigment is $TiO_2$, the light used will generally be predominantly ultraviolet light in the wavelength range 350 to 400 nm. For other pigments other wavelengths are appropriate as is known in the art. The time of exposure depends *inter alia* on the intensity of the radiation, the thickness of the resin to be cured and the nature and concentration of the photoinitiator and photoactivator. We have found that in the present invention exposures of less than $\frac{1}{2}$ sec. using a single lamp ($80Wcm^{-1}$) Minicure oven for thin films of $TiO_2$ pigmented resin are adequate to give a hard (>6H pencil hardness) layer of cured pigmented resin. The use of thicker layers of resin or lower radiation intensities will generally require longer exposure times.

The photoactivators used in the present invention have an activity which is comparable to that of ortho-dialkylaminobenzoate esters such as are described in our British Application No. 52202/76 (Specification No. 1547919). However, the compounds used in the present invention have the advantage that, especially when they are used with thioxanthone photoinitiators or dibenzosuberone or fluorenone, they produce cured resins which are less yellow in colour. This is a particular advantage when the photoactivators are used in the production of clear or white pigmented products. The paradialkylamino benzoate esters, whose use is described in German Offenlegungsschrift No. 2458345, produce cured resins that are more yellow than those obtained using the corresponding ortho-isomers, when used in conjunction with this class of photoinitiators. Further their use with photoinitiators of the thioxanthone type is made more difficult because the para-dialkylaminobenzoate esters generally have higher melting points than the corresponding compounds used in the present invention, and are usually solid thus making the formulation of liquid photoinitiator-photoactivator combinations more difficult. German Offenlegungsschrift 2458345 describes the use of para-dialkylaminobenzoate esters only in conjunction with a restricted class of benzophenone type photoinitiators.

The possibility of incorporating pigments into the resin products has been mentioned above. The invention is applicable to cured resin products containing no pigment and to those containing pigments which may be white, e.g. titanium dioxide, or coloured. The invention is also applicable to products which are clear but are coloured by containing a soluble dyestuff. Of course, where pigmented or dyed products are being produced the precise conditions of operation may need to be adjusted in order to take account of the possibility of dispersion or absorption of the curing radiation by the pigment or dyestuff. This is a problem that is well understood in the art and no particular difficulty arises in dealing with it in the present invention.

The aminoalkyl esters used as photoactivators in the present invention can be made by methods which are known or analogous to methods known *per se* for similar compounds. The following reaction schemes illustrate some ways in which the compounds of the invention can be made. Experimental details are not included because these are either readily found or known from the literature.

I synthesis of A.OH

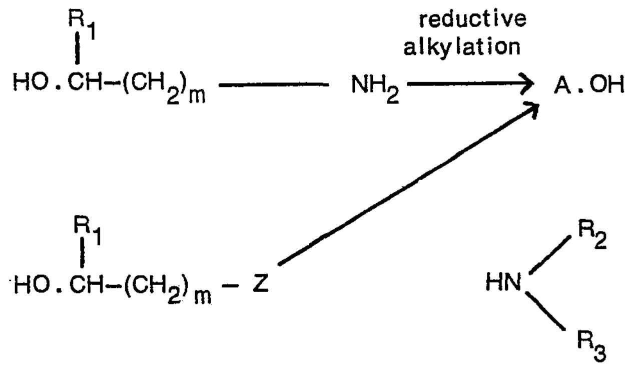


The alcohols A.OH can be made by reductive alkylation of the corresponding primary amino-alcohols which are in general known compounds, or by nucleophilic substitution on the corresponding halogen substituted alcohol using a secondary amine already carrying $R_2$ and $R_3$. Many of the N,N-dialkylamino ethanols of the formula A.OH are themselves known.

II. Synthesis of 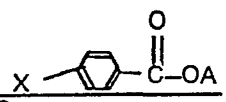

(i) X is not 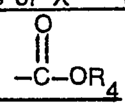

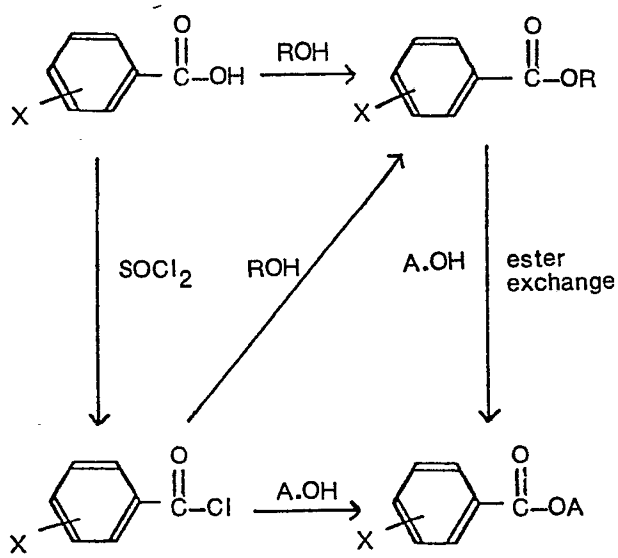

(ii) X is $-\overset{O}{\overset{\|}{C}}-OR_4$

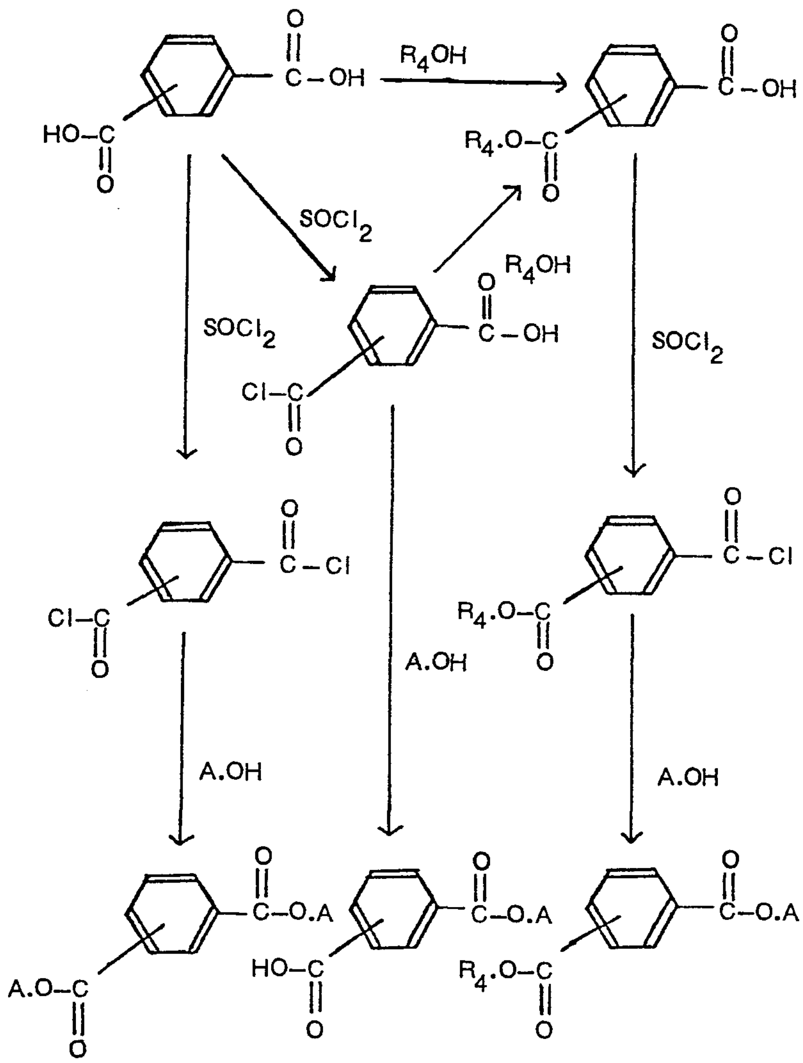


In the above reaction schemes, m, A, X, $R_1$, $R_2$, $R_3$ and $R_4$, have the meanings given above; Z is halogen, e.g. Cl or Br and R is an alkyl, preferably lower alkyl, especially methyl or ethyl group, suitable for ester exchange.

The following Examples illustrate the invention. In these Examples Uvimer D.V.530 resin was used. This resin is a commercially available acrylated aromatic polyurethane resin. The grade of titanium dioxide pigment used in the Example is R—TC2 grade. All film samples were cured by exposing them for the stated time using a single lamp (80 $Wcm^{-1}$) Minicure oven.

Example 1

2-Dimethylaminoethyl benzoate

*Preparation*

Dimethylaminoethanol (44.5 g; 0.5 mol.) and sodium bicarbonate (45 g) were stirred in chloroform (200 ml) and cooled to 5°C. Benzoyl chloride (78 g; 0.55 mol.) was added dropwise over four hours maintaining the temperature at 5—10°C with ice cooling. The reaction mixture was stirred for 18 hours, allowing the temperature to rise slowly to 20°C. Water (250 ml) was added slowly over half an hour with evolution of carbon dioxide and some tendency to froth. The mixture was separated and the upper aqueous layer extracted with chloroform (50 ml). The combined chloroform layers were washed with water (50 ml) and stripped of all solvent on a rotary evaporator up to 100°C. The residue (100—104 g) was transferred to a Vigreux flask and distilled under high vacuum. Yield 82.2—83.6 g, 85.2—86.6% based on dimethylaminoethanol. Colourless mobile liquid, b.pt. 93—98°C/1.3 mm. Assay (GLC) 97.4—97.6%.

*Alternative Preparation (via ester exchange)*

40 ml. ethyl benzoate (0.28 M), 30 ml. N,N-dimethylaminoethanol (0.30 M) and 100 ml. dry toluene were refluxed together until all the extraneous water present has been removed via a partial takeoff head.

The solution was allowed to cool below boiling point, 1 g of dry sodium methoxide was added and the solution refluxed for four hours. Fractions of boiling point between 80 and 100°C were run off until the temperature at the still-head was a constant 108°C. The solution was then allowed to cool below the boil, a further 1 g of sodium methoxide added, and refluxed overnight, fractions being run off until a constant temperature of 108—110°C was achieved at the stillhead.

The hot solution was filtered, 1 g charcoal added, refluxed for fifteen minutes, filtered, washed with water (100 ml. x 2), dried with magnesium sulphate, filtered and rotaried to give a pale yellow liquid, 98.2% pure by G.L.C., 93.8% by non-aqueous titration (27.0 g corresponding to 52% yield).

On high vacuum distillation, a colourless liquid, 98.1% pure by G.L.C., 99.1% pure by non-aqueous titration, was obtained.

*Microanalysis:*

| % Wt. | $C_{11}$ | $H_{15}$ | N | $O_2$ |
|---|---|---|---|---|
| Theoretical | 68.36 | 7.82 | 7.25 | 16.56 |
| Actual | 67.98 | 7.65 | 6.98 | 17.39 (by difference) |

*Physical Properties:*

Colourless, odourless transparent liquid

Boiling Point: 88—89°C at 1.2—1.5 mm/Hg
106—110°C at 2.8 mm/Hg
107—108°C at 2 mm/Hg.

*Photoactivator Activity*

A formulated resin coating consisting of 2% $^w/_w$ 2-dimethylaminoethyl benzoate, 0.2% $^w/_w$ 2-chlorothioxanthone (2—CTX) or 0.2% $^w/_w$ 2-isopropylthioxanthone, 40% $^w/_w$ titanium dioxide pigment Uvimer D.V. 530 resin applied as a 25 micron film photocured to pencil hardness >6H in 0.15 seconds. The photocured film was of high gloss and less yellow to the eye when viewed in daylight when compared to that produced under similar conditions using 0.2% $^w/_w$ 2-isopropylthioxanthone together with 2% $^w/_w$ ethyl *o*-dimethylaminobenzoate.

Example 2

*2-Diethylaminoethyl benzoate*

*Preparation*

As described in Example 1 but substituting 2-(N,N-diethylamino)ethanol for the 2-(N,N-dimethylamino)ethanol used in Example 1.

*Photoactivator Activity*

A formulated resin coating consisting of 2% $^w/_w$ 2-diethylaminoethyl benzoate, 0.2% $^w/_w$ 2—CTX, 40% $^w/_w$ titanium dioxide pigmented D.V. 530 resin applied as a 25 micron film photocured to pencil hardness >6H in 0.2 seconds. The photocured film was of high gloss and less yellow to the eyes when viewed in daylight when compared with the reference film given in Example 1.

Example 3

2-Dimethylaminoethyl p-tertbutylbenzoate

*Preparation*

Dimethylaminoethanol (13.35 g; 0.15 mol.) was stirred in water (60 ml) with sodium hydroxide pellets (6.0 g; 0.15 mol) *p*-tert.-butylbenzoyl chloride (26.7 g; 0.136 mol) was added over half an hour at room temperature. The mixture was stirred overnight and extracted with dichloromethane (100 ml). The dichloromethane solution was washed with 5% sodium bicarbonate (100 ml) and water (50 ml) and stripped of all solvent on a Rotavapor. The residue (13.7 g) was distilled under vacuum from a Vigreux column. Yield 11.1 g. b.pt. 151.5—153.5°C/0.7 mm. Assay (GLC) 99.7%.

Yield 29.7% on dimethylaminoethanol; 33.0% on P-tert.-butylbenzoyl chloride.

*Photoactivator Activity*

A formulated resin coating consisting of 2% $^w/_w$ 2-dimethylaminoethyl *O*-tert.-butylbenzoate, 0.2% $^w/_w$ 2—CTX, 40% $^w/_w$ titanium dioxide pigmented D.V. 350 resin applied as a 25 micron film photocured to pencil hardness >6H in 0.225 seconds. The photocured film was of high gloss and less yellow to the eye when viewed in daylight when compared with the reference film given in Example 1.

## Example 4

3-Dimethylaminopropyl benzoate

*Preparation*

The ester exchange procedure described in Example 1 (alternative procedure) was used but substituting 3 (N,N-dimethylamino) propanol for the 2-(N,N-dimethylamino) ethanol used in Example 1.

*Photoactivator activity*

A formulated resin consisting of 2% w/w 3- dimethylaminopropyl benzoate, 0.2% w/w 2—C.T.X., 40% w/w titanium dioxide pigmented D.V. 530 resin applied as a 25 micron film photocured to pencil hardness >6H in 0.15 seconds. The photocured film was of high gloss and less yellow to the eyes when viewed in daylight when compared with the reference film of Example 1.

## Example 5

1-Dimethylamino-2-propyl benzoate

*Preparation*

Benzoyl chloride (29 mls.; 0.25 mol) was added during thirty minutes to a stirred solution of 1.-dimethylamino-propan-2-ol (31 mls; 0.30 mol) in a mixture of triethylamine (34 mls) and dichloromethane (200 mls). The temperature was maintained at ambient temperature by intermittent cooling. After stirring over-night, the mixture was filtered, the filtrate washed with water (100 mls x 2) dried over magnesium sulphate, filtered and after removal of the solvent, distillation gave 1-dimethylamino-2-propyl benzoate (14.22 g; yield = 26.8%) as a colourless oil of boiling point 89—90°C/1.1 mm. Assay (G.L.C. = 96.2%; non aqueous titration = 98.7%.)

*Photoactivator activity*

A formulated resin coating consisting of 2% w/w 1-dimethylamino-2-propyl benzoate, 0.2% w/w 2—C.T.X., 40% w/w titanium dioxide pigmented D.V. 530 resin applied as a 25 micron film photocured to pencil hardness >6H in 0.15 seconds. The photocured film was of high gloss and less yellow to the eyes when viewed in daylight when compared with the reference film of Example 1.

## Example 6

2-Dimethylaminoethyl 4'-methylbenzoate

*Preparation*

The reaction sequence described in Example 5 was used but substituting 2-dimethylaminoethanol and p-toluyl chloride for the 1-dimethylaminopropane-2-ol and benzoyl chloride respectively used in Example 5. A colourless oil of boiling point 115°C/2.2 mm was obtained.

*Microanalysis*

| % Weight | $C_{12}$ | $H_{17}$ | N | $O_2$ |
|---|---|---|---|---|
| Theoretical | 69.54 | 8.27 | 6.76 | 15.43 |
| Actual | 69.38 | 8.28 | 6.61 | 15.73 |

*Photoactivator activity*

The testing method of Example 1 was used to test 2-dimethylaminoethyl 4'-methylbenzoate giving pencil hardness >6H in 0.15 seconds. The photocured film was of high gloss and less yellow to the eyes when viewed in the daylight when compared with the reference film of Example 1.

## Example 7

2-Dimethylaminoethyl 3'-chlorobenzoate

*Preparation*

The reaction sequence described in Example 5 was used but substituting 2-dimethylaminoethanol and m-chlorobenzoyl chloride for the 1-dimethylaminopropan-2-ol and benzoyl chloride respectively used in Example 5. A colourless oil of boiling point 130—132°C/4 mm was obtained.

*Microanalysis*

| % Weight | $C_{11}$ | $H_{14}$ | Cl | N | $O_2$ |
|---|---|---|---|---|---|
| Theoretical | 58.02 | 6.20 | 15.57 | 6.15 | 14.06 |
| Actual | 58.07 | 6.13 | 15.38 | 6.10 | 14.32 (by diff.) |

*Photoactivator activity*

The testing method of Example 1 was used to test 2-dimethylaminoethyl 3'-chlorobenzoate giving pencil hardness >6H in 0.2 seconds. The photocured film was of high gloss and less yellow to the eyes when viewed in daylight when compared with the reference film of Example 1.

Example 8

2-Dimethylaminoethyl anisoate

*Preparation*

The reaction sequence described in Example 5 was used substituting 2-dimethylaminoethanol and anisoyl chloride for 1-dimethylaminopropan-2-ol and benzoyl chloride respectively. The crude reaction product was purified by column chromatography rather than vacuum distillation. A colourless oil of $R_f$=0.27 on silica with ethanol elutant was obtained.

*Microanalysis*

| % Weight | $C_{12}$ | $H_{17}$ | N | $O_3$ |
|---|---|---|---|---|
| Theoretical | 64.55 | 7.67 | 6.27 | 21.51 |
| Actual | 64.28 | 7.56 | 6.24 | 21.92 (by diff.) |

*Photoactivator activity*

The testing method of Example 1 was used to test 2-dimethylaminoethyl anisoate giving pencil hardness >6H in 0.15 seconds. The photocured film was of high gloss and less yellow to the eyes when viewed in daylight when compared with the reference film of Example 1.

Example 9

Bis-(2-[N,N-dimethylamino]ethyl) terephthalate

*Preparation*

Terephthaloyl dichloride (10 g; 0.05 moles) was added during thirty minutes to a stirred mixture of 2-dimethylaminoethanol (8.9 g; 0.2 mols) and toluene (150 mls) whilst the temperature was maintained at 5±5°C by intermittent cooling. The mixture was then stirred at 90°C for 4 hours followed by evaporation of the solvent under vacuum. The residual solid was triturated with a solution of sodium hydroxide (8 g) in water (100 mls) and the liberated oil extracted with ether (25 mls x 3). The combined ethereal extracts were washed with water (50 mls) dried over magnesium sulphate, filtered and the solvent evaporated to give the crude title compound (5.86 g) as an oil which was purified by vacuum distillation Bis-(2- [N,N-dimethylamino] ethyl) terephthalate (4.0 g, yield = 26.0%) was obtained as a colourless oil of boiling point 155°C/0.05 mm.

Assay G.L.C. = 99.1%; non aqueous titration = 97.8%.

*Microanalysis*

| % Weight | $C_{16}$ | $H_{24}$ | $N_2$ | $O_4$ |
|---|---|---|---|---|
| Theoretical | 62.32 | 7.84 | 9.08 | 20.75 |
| Actual | 62.12 | 7.68 | 8.95 | 21.25 (by diff.) |

*Photoactivator activity*

A formulated resin coating composition consisting of 2% w/w bis- (2- [N,N-dimethylamino] ethyl) terephthalate, 0.2% w/w 2—C.T.X., 40% titanium dioxide pigmented D.V. 530 resin applied as a 25 micron film photocured to pencil hardness >6H in 0.15 seconds. The photocured film was of high gloss and less yellow to the eyes when viewed in daylight when compared with the reference film of Example I.

Example 10

2-Dimethylaminoethyl 4' - Methylthiobenzoate

*Preparation*

The synthetic route described in Example 5 was used substituting 2-dimethylaminoethanol and p-methylthiobenzoyl chloride for the 1-dimethylaminopropan 2-ol and benzoyl chloride respectively. A colourless oil of boiling point 156—158°C/2 mm. was obtained Assay via non-aqueous titration = 98.5%.

*Microanalysis*

| % Weight | $C_{12}$ | $H_{17}$ | N | S | $O_2$ |
|---|---|---|---|---|---|
| Theoretical | 60.22 | 7.16 | 5.85 | 13.40 | 13.40 |
| Actual | 60.4 | 7.29 | 5.60 | 13.5 | 13.57 (by diff.) |

*Photoactivator activity*

The test method described in Example I was used giving pencil hardness >6H in 0.15 seconds. The photocured film was of high gloss and less yellow to the eyes when viewed in daylight when compared with the reference film of Example I.

Example 11

Comparative testes were run on three resins for wood varnish or lacquer applications using various photoinitiators. Resin A is an acrylic resin, resin B an acrylated epoxy resin and resin C an acrylated urethane resin. The resins were formulated with the photinitiator and photoactivator (when present) and 25 micron thick clear (i.e. unpigmented) coatings were cured by exposure in the Minicure oven. The time taken for the test films to harden to a pencil hardness of >6H were recorded and are set in the Table below. In the Table comparative results are quoted for Irgacure 651 which is a substituted acetophenone-type photoinitiator (2,2-dimethoxy - 2-phenylacetophenone) not customarily employed with photoactivators. ("Irgacure" is a Registered Trade Mark).

The abbreviations are:

D B S = dibenzosuberone

D M B = 2-dimethylaminoethyl benzoate

I T X = isopropylthioxanthone

The quantities of photoinitiators are wt% on the resin.

TABLE

| Photoinitiator | Photoactivator | Cure Time (secs) | | |
|---|---|---|---|---|
| | | A | B | C |
| Irgacure 651 4% (for comparison) | | 2 | .5 | .5 |
| D B S 4% | D M B 4% | .25 | .05 | .1 |
| D B S 2% | D M B 2% | .5 | .25 | .25 |
| D B S 1% | D M B 1% | 1 | .5 | .5 |
| I T X 2% | D M B 2% | 1 | .25 | .25 |

**Claims**

1. A photocurable composition comprising a photocurable ethylenically unsaturated compound, a photoinitiator and a photoactivator characterised in that the photoactivator comprises a compound or a mixture of compounds of the general formula:

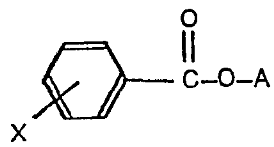

where A is a group of the formula:

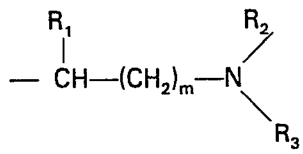

where m is an integer of from 1 to 5;

$R_1$ is hydrogen atom or a straight or branched chain alkyl group;

$R_2$ and $R_3$ are the same or different and each is an alkyl group;

X is a hydrogen or a halogen atom or a straight or branched chain alkyl or alkoxy group or a grop of the formula:

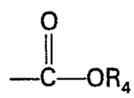

where $R_4$ is a hydrogen atom, a straight or branched chain alkyl group, or a group of the formula A as defined above or X is an alkylthio group.

2. A composition as claimed in Claim 1 further characterized in that:

$R_1$ is a hydrogen atom or an alkyl group having from 1 to 3 carbon atoms;

$R_2$ and $R_3$ are each a methyl or ethyl group;

X is a hydrogen or chlorine atom, an alkyl, alkoxy or alkylthio group having from 1 to 6 carbon atoms or a group of the formula:

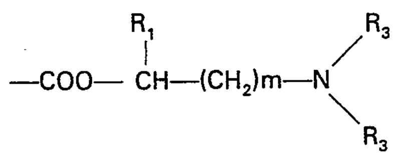

where $R_1$, $R_2$ and $R_3$ are as defined above and m is an defined in Claim 1.

3. A composition as claimed in claim 2 and further characterised in that the photoactivator is 2-dimethylaminoethyl benzoate.

4. A composition as claimed in any one of claims 1 to 3 further characterised in that the amount of photoactivator is from 0.2 to 5% by weight of the composition.

5. A composition as claimed in any one of claims 1 to 4 further characterised in that the photoinitiator is 2-chlorothioxanthone or a 2-alkylthioxanthone.

6. A composition as claimed in any one of claims 1 to 5 further characterised in that the amount of photoinitiator is from 0.1 to 5% by weight of the composition.

7. A composition as claimed in any one of claims 1 to 6 further characterised in that the weight ratio of photoactivator to photoinitiator is in the range of from 1:4 to 100:1.

8. A composition as claimed in any one of claims 1 to 7 further characterised in that it contains at least one pigment or dye.

9. A photoactivator-photoinitiator combination characterized in that it comprises as a photoactivator a compound or a mixture of compounds of the formula:

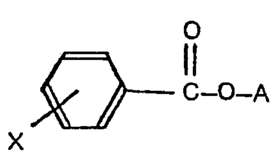

where A and X are as defined in either claim 1 or claim 2.

10. A photoactivator-photoinitiator combination characterised in that it comprises a photoinitiator of the formula:

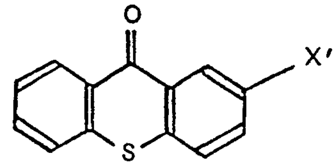

where X' is a chlorine atomor an alkyl group; in solution in a photoactivator which is a compound or mixture of compounds of the formula:

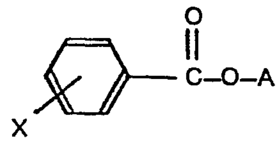

where A and X are as defined in either claim 1 or claim 2.

11. A combination as claimed in either claim 9 or claim 10 further characterised in that the concentration of the photoinitiator is from 1 to 20% w/w of the combination.

12. A composition as claimed in any one of claims 1 to 8 further characterised in that the photoinitiator and photoactivator are provided by inclusion of from 1 to 5% by weight of the composition of a combination as claimed in any one of claims 9 to 11.

13. A method of making a cured plastics composition characterised in that a composition as claimed in any one of claims 1 to 8 and 12 is exposed to a dose of actinic radiation sufficient to cure it.

**Patentansprüche**

1. Eine photohärtbure Zusammensetzung im wesentlichen bestehend aus einer photohärtbaren, äthylenisch ungesättigten Verbindung, einem Photoinitiator und einem Photoaktivator, dadurch gekennzeichnet, daß der Photoaktivator im wesentlichen besteht aus einer Verbindung oder einer Mischung von Verbindungen der allgemeinen Formel

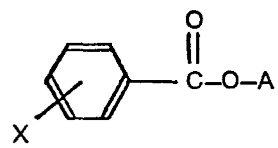

in welcher A eine Gruppe der Formel

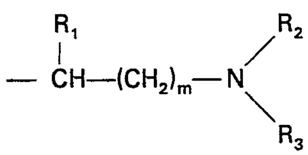

ist, worin m eine ganze Zahl von 1 bis 5 ist;

$R_1$ ein Wasserstoffatom oder eine geradkettige oder verzweigtkeittige Alkylgruppe darstellt; $R_2$ und $R_3$ gleich oder verschieden sind und jeweils eine Alkylgruppe bedeuten;

X ein Wasserstoffatom oder ein Halogenatom oder eine geradkettige oder verzweigtkettige Alkyl- oder Alkoxygruppe oder eine Gruppe der Formei

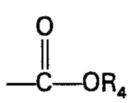

in welcher $R_4$ ein Wasserstoffatom, eine geradkettige oder verzweigtkettige Alkylgruppe oder eine Gruppe der Formel A wie oben definiert bedeutet, oder X eine Alkylthiogruppe darstellt.

2. Eine Zusammensetzung gemäß Anspruch 1, weiterhin dadurch gekennzeichnet, daß:

$R_1$ ein Wasserstoffatom oder eine Alkylgruppe mit 1 bis 3 Kohlenstoffatomen darstellt:

$R_2$ und $R_3$ jeweils eine Methyl-oder Äthylgruppe bedeuten;

X eine Wasserstoff-oder Chloratom, eine Alkyl-, Alkoxy- oder Alkylthio-Gruppe mit 1 bis 6 Kohlenstoffatomen oder eine Gruppe der Formel

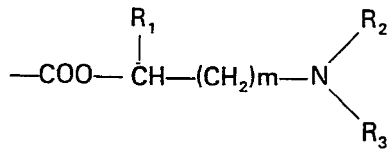

worin $R_1$, $R_2$ und $R_3$ wie oben definiert sind und m wie in Anspruch 1 definiert ist, darstellt.

3. Eine Zusammensetzung gemäß Anspruch 2 und weiterhin dadurch gekennzeichnet, daß der Photoaktivator 2-Dimethylaminoäthylbenzoat ist.

4. Eine Zusammensetzung gemäß einem der Ansprüche 1 bis 3 weiter dadurch gekennzeichnet, daß die Menge an Photoaktivator 0.2 bis 5 Gew.-% der Zusammensetzung beträgt.

5. Eine Zusammensetzung gemäß einem der Ansprüche 1 bis 4 weiter dadurch gekennzeichnet, daß der Photoinitiator 2-Chlorothioxanthon oder ein 2-Alkylthioxanthon ist.

6. Eine Zusammensetzung gemäß einem der Ansprüche 1 bis 5 weiter dadurch gekennzeichnet, daß die Menge an Photoinitiator von 0,1 bis 5 Gew.-% der Zusammensetzung ausmacht.

7. Eine Zusammensetzung gemäß einem der Ansprüche 1 bis 6 weiter dadurch gekennzeichnet, daß das Gewichtsverhältnis von Photoaktivator zu Photoinitiator im Bereich von 1:4 bis 100:1 liegt.

8. Eine Zusammensetzung gemäß einem der Ansprüche 1 bis 7 weiter dadurch gekennzeichnet, daß sie mindestens ein Pigment oder einen Farbstoff enthält.

9. Eine Photoaktivator-Photoinitiator- Kombination dadurch gekennzeichnet, daß sie als Photoaktivator eine Verbindung oder eine Mischung von Verbindungen der Formel

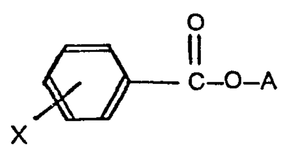

worin A und X wie in einem der Ansprüche 1 oder 2 definiert sind, umfaßt.

10. Eine Photoaktivator-Photoinitiator-Kombination dadurch gekennzeichnet, daß sie einen Photoinitiator der Formel

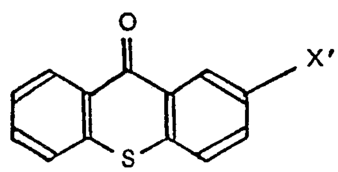

worin X' ein Chloratom oder eine Alkylgruppe ist, in Lösung in einem Photoaktivator, der eine Verbindung oder eine Mischung von Verbindungen der Formel

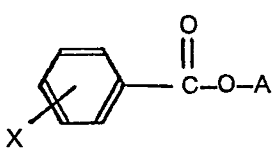

worin A und X wie in Anspruch 1 oder 2 definiert sind, umfaßt.

11. Eine Kombination gemäß einem der Ansprüche 9 oder 10 weiter dadurch gekennzeichnet, daß die Konzentration des Photoinitiators 1 bis 20 Gew.-% der Kombination beträgt.

12. Eine Zusammensetzung gemäß einem der Ansprüche 1 bis 8 weiter dadurch gekennzeichnet, daß der Photoinitiator und der Photoaktivator geliefert werden durch Einschluß von 1 bis 5% bezogen auf das Gewicht der Zusammensetzung einer Kombination wie beansprucht in einem der Ansprüche 9 bis 11.

13. Eine Verfahren zur Herstellung einer ausgehärteten Kunststoffzusammensetzung dadurch gekennzeichnet, daß eine Zusammensetzung wie beansprucht in einem der Ansprüche 1 bis 8 und 12 einer Dosis eines Lichtquants ausreichend für die Aushärtung ausgesetzt wird.

**Revendications**

1. Composition photoréticulable comprenant un composé photoréticulable éthyléniquement insaturé, un photo-initiateur et un photo-activateur, caractérisée en ce que le photo-activateur comprend un composé ou un mélange de composés de formule générale

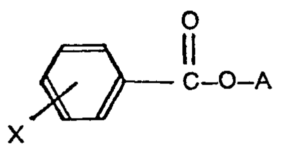

où A est un groupe de formule

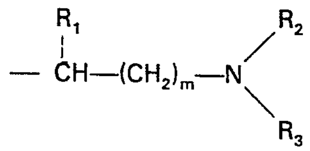

où m est un nombre entier compris entre 1 et 5;

$R_1$ est un atome d'hydrogène ou un groupe alcoyle à chaîne droite ou ramifiée;

$R_2$ et $R_3$ sont semblables ou différents et chacun d'eux représente un groupe alcoyle;

X est un atome d'hydrogene ou d'halogène ou un groupe alcoyle ou alcoxy à chaîne droite ou ramifiée ou un groupe de formule

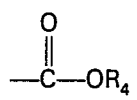

où

$R_4$ est un atome d'hydrogène, un groupe alcoyle à chaîne droite ou ramifiée, ou un groupe de formule A telle que définie ci-dessus ou X est un groupe alcoylthio.

2. Composition telle que revendiquée dans la rev. 1, caractérisée en outre en ce que:

$R_1$ est un atome d'hydrogène ou un groupe alcoyle ayant de 1 à 3 atomes de carbone;

$R_2$ et $R_3$ représentent chacun un groupe méthyle ou éthyle;

X est un atome d'hydrogène ou de chlore, un groupe alcoyle, alcoxy ou alcoylthio ayant de 1 à 6 atomes de carbone ou un groupe de formule

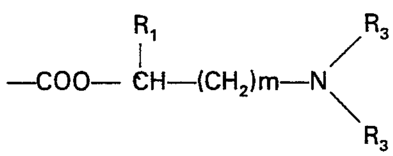

où $R_1$, $R_2$ et $R_3$ sont tels que définis ci-dessus et où m est tel que défini dans la revendication 1.

3. Composition telle que revendiquée dans la revendication 2 et caractérisée en outre en ce que le photo-activateur est le 2-diméthylaminoéthylbenzoate.

4. Composition telle que revendiquée dans l'une quelconque des revendications 1 à 3, caractérisée en outre en ce que la quantité de photo-activateur varie de 0,2 à 5% en poids de la composition.

5. Composition telle que revendiquée dans l'une quelconque des revendications 1 à 4, caractérisée en outre en ce que le photo-initiateur est la 2-chlorothioxanthone ou une 2-alcoylthioxanthone.

6. Composition telle que revendiquée dans l'une quelconque des revendications 1 à 5, caractérisée en outre en ce que la quantité de photo-initiateur varie de 0,1 à 5% en poids de la composition.

7. Composition telle que revendiquée dans l'une des quelconque des revendications 1 à 6, caractérisée en outre en ce que le rapport pondéral du photo-activateur au photo-initiateur est dans un intervalle de 1:4 à 100:1.

8. Composition telle que revendiquée dans l'une quelconque des revendications 1 à 7, caractérisée en outre en ce qu'elle contient au moins un pigment ou une teinture.

9. Combinaison photo-activateur-photo-initiateur caractérisée en ce qu'elle comprend comme photo-activateur un composé ou mélange de composés de formule

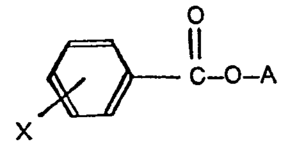

où A et X sont tels que définis dans la revendication 1 ou dans la revendication 2.

10. Combinaison photo-activateur-phosot-initiateur caractérisée en ce qu'elle comprend un photo-initiateur de formule

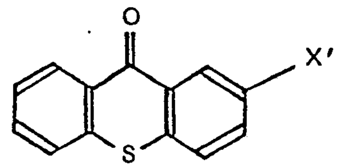

où X' est un atome de chlore ou un groupe alcoyle; en solution dans un photo-activateur qui est un composé ou un mélange de composés de formule

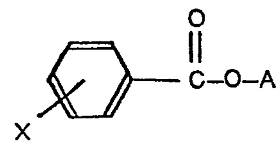

où A et X sont tels que définis dans la revendication 1 ou dans la revendication 2.

11. Combinaison telle que revendiquée dans la revendication 9 ou dans la revendication 10, caractérisée en outre en ce que la concentration du photo-initiateur varie entre 1 et 20% p/p de la combinaison.

12. Composition telle que revendiquée dans l'une quelconque des revendications 1 à 8, caractérisée en outre en ce que le photo-initiateur et le photo-activateur sont fournis par inclusion de 1 à 5% en poids de la composition d'une combinaison telle que revendiquée dans l'une quelconque des revendications 9 à 11.

13. Procédé de préparation d'une composition plastique réticulée caractérisée en ce qu'on expose une composition telle que revendiquée dans l'une quelconque des revendications 1 à 8 et 12 à une dose de rayonnement actinique suffisante pour la réticuler.